# EUROPÄISCHE PATENTSCHRIFT

(11) **EP 2 689 507 B1**
(45) Veröffentlichungstag und Bekanntmachung des Hinweises auf die Patenterteilung: **19.07.2017**
(21) Anmeldenummer: 11711823.2
(22) Anmeldetag: 24.03.2011
(51) Int. Cl.: H02H 3/38, H02H 3/16, G01R 31/08

(54) **RICHTUNGSBESTIMMUNG VON INTERMITTIERENDEN ERDFEHLERN IN ENERGIEVERSORGUNGSNETZEN**
DETERMINING THE DIRECTION OF INTERMITTENT EARTH FAULTS IN ENERGY SUPPLY NETWORKS
DÉTERMINATION DE LA DIRECTION DES DÉFAUTS DE TERRE INTERMITTENTS DANS DES RÉSEAUX DE DISTRIBUTION ÉLECTRIQUE

(43) Veröffentlichungstag der Anmeldung: 29.01.2014
(73) Patentinhaber: Siemens Aktiengesellschaft, 80333 München (DE)
(72) Erfinder: BÖHME, Klaus, 12305 Berlin (DE); WERBEN, Stefan, 91207 Lauf A.D.P. (DE)
(86) Internationale Anmeldenummer: PCT/EP2011/054527
(87) Internationale Veröffentlichungsnummer: WO 2012/126526

(56) Entgegenhaltungen:
- EP-A2- 1 388 920
- WO-A1-2005/038474
- DE-B1- 2 618 080
- DE-B3- 10 302 451
- GB-A- 2 046 039
- US-A- 5 572 138

## Beschreibung

Die Erfindung betrifft ein Verfahren zum Erzeugen eines Richtungssignals, das eine Richtung angibt, in der sich ein intermittierender Erdfehler in einem elektrischen Energieversorgungsnetz befindet, wobei einen Nullstrom angebende Nullstrommesswerte und eine Nullspannung angebende Nullspannungswerte erfasst und von einem Schutzgerät zur Bildung des Richtungssignals herangezogen werden, wobei Stromspitzenwerte als derjenige Anteil aus dem Verlauf der Nullstrommesswerte bestimmt werden, der zumindest eine einen intermittierenden Erdfehler angebende Stromspitze umfasst, und die Phasenlage des Verlaufs der Stromspitzenwerte mit der Phasenlage des Verlaufs der Nullspannungsmesswerte verglichen wird. Die Erfindung betrifft auch ein entsprechendes eingerichtetes Schutzgerät.

Ein solches Verfahren ist beispielsweise aus der WO 2005/038474 A1, das den Oberbegriff der unabhängigen Ansprüche bildet, bekannt.

In elektrischen Energieversorgungsnetzen, insbesondere in Kabelnetzen mit isoliertem oder gelöschtem Sternpunkt, können kurzfristige, wiederkehrende Erdfehler - so genannte "intermittierende Erdfehler" - auftreten, die beispielsweise durch eine fehlerhafte Isolation elektrischer Kabel verursacht werden. Beispielsweise kann durch Alterungseffekte die Isolation von elektrischen Erdkabeln teilweise brüchig werden, so dass an den fehlerhaften Stellen kurzfristige, wiederkehrende Lichtbogenüberschläge auftreten, die zwar von selbst wieder verlöschen, später jedoch erneut wieder zünden. Solche intermittierenden Erdfehler müssen von Schutzgeräten in elektrischen Energieversorgungsnetzen selektiv erfasst werden. Diesbezüglich ist insbesondere die Angabe über eine Richtung (vorwärts/rückwärts) von Interesse, in der ein intermittierender Erdfehler von dem Schutzgerät aus gesehen auftritt.

Zur Erkennung eines intermittierenden Erdfehlers in einem elektrischen Energieversorgungsnetz ist beispielsweise aus der finnischen Offenlegungsschrift FI 20070744 A bekannt, an einer Mittelspannungsschiene einer Schaltstation die Nullspannung und an einzelnen von der Sammelschiene abgehenden Abzweigleitungen den jeweils fließenden Nullstrom zu messen. Auf einen Fehler in dem jeweiligen Abzweig wird gemäß dem bekannten Verfahren dann geschlossen, wenn der Momentanwert des Nullstroms einen voreingestellten Schwellenwert überschreitet und in der nächsten Periode der Grundschwingung die Nullspannung ebenfalls einen voreingestellten Schwellenwert überschreitet. Zudem wird das Nullspannungssignal bezüglich der Zeit differenziert, und es werden das Nullstromsignal und das Signal der differenzierten Nullspannung bezüglich einer der Netzfrequenz am nächsten liegenden Komponente gefiltert und eine Korrelation zwischen den auf diese Weise gefilterten Signalen berechnet. Wenn der intermittierende Erdfehler auf dem fraglichen Abzweig liegt, zeigt die Korrelation ein negatives Ergebnis, während bei einem fehlerfreien Abzweig die Korrelation ein positives Ergebnis ergibt.

Auch aus der DE 103 02 451 B3 ist ein Verfahren zur Richtungsbestimmung eines intermittierenden Erdfehlers beschrieben, bei dem das Vorhandensein eins Erdfehlers anhand des Aufladeverhaltens überwachter Streckenabzweige bestimmt wird.

Der Erfindung liegt die Aufgabe zu Grunde, die Richtung eines intermittierenden Erdfehlers vergleichsweise einfach und schnell erkennen zu können.

Hierzu wird bezüglich eines Verfahrens der eingangs genannten Art vorgeschlagen, dass die Nullstrommesswerte und die Nullspannungsmesswerte an derselben Messstelle des Energieversorgungsnetzes erfasst werden, und ein Richtungssignal erzeugt wird, das einen bezüglich der Messstelle in Vorwärtsrichtung liegenden intermittieren den Erdfehler anzeigt, wenn die Phasenlage der Stromspitzenwerte mit der Phasenlage der Stromspitzenwerte mit der Phasenlage der Nullspannungswerte übereinstimmt .

Der Erfindung liegt die Erkenntnis zu Grunde, dass der zeitliche Ablauf eines intermittierenden Erdfehlers prinzipiell aus zwei unterschiedlichen Phasen zusammengesetzt ist. In der ersten zeitlichen Phase tritt der Stromüberschlag auf. Diese Phase ist durch einen kurzen, meist im Bereich weniger Millisekunden liegenden stromstarken Impuls gekennzeichnet. Dieser Impuls ist der eigentliche Fehlerstrom und weist eine Phasenlage auf, die entweder nahezu der Phasenlage der entsprechenden Nullspannung entspricht oder in Gegenphase zur Nullspannung verläuft. Die zweite zeitliche Phase umfasst einen Ausgleichsvorgang, der nach dem Löschen des Lichtbogens auftritt. Dieser Ausgleichsvorgang ist durch einen sinusförmigen, langsam abklingenden Strom gekennzeichnet, der einen Phasenbezug von etwa 90° zur Nullspannung aufweist. Eine einfache Betrachtung der Phasenbezüge des Nullstromes und der Nullspannung zueinander kann daher keine eindeutigen Richtungsergebnisse liefern, da sich die Phasenlage des Nullstromes beim Übergang von der ersten auf die zweite beschriebene zeitliche Phase um bis zu 90° ändert.

Für die Richtungsbestimmung wird gemäß dem erfindungsgemäßen Verfahren daher zunächst eine Aufteilung des Nullstromes vorgenommen, um die dem Lichtbogen zugehörigen Anteile vom restlichen Nullstrom unter Bildung von Stromspitzenwerten abzutrennen. Da diese zu der beschriebenen ersten zeitlichen Phase gehörenden Stromspitzenwerte abhängig von der Richtung des intermittierenden Erdfehlers hinsichtlich der zugehörigen Nullspannung eine eindeutige Phasenlage aufweisen, können die Stromspitzenwerte als Kriterium zur Erkennung der Fehlerrichtung herangezogen werden. Wird bei dem erfindungsgemäßen Verfahren nämlich erkannt, dass die Phasenlage der Stromspitzenwerte mit der Phasenlage der Nullspannungswerte übereinstimmt, so wird ein Richtungssignal abgegeben, das angibt, dass ein intermittierender Erdfehler in Vorwärtsrichtung (von der Messstelle des Schutzgerätes aus gesehen) vorliegt.

Das beschriebene erfindungsgemäße Verfahren liefert daher auf einfache Weise und sehr schnell ein eindeutiges Ergebnis über die Fehlerrichtung eines intermittierenden Erdfehlers.

Gemäß einer vorteilhaften Ausführungsform des erfindungsgemäßen Verfahrens ist vorgesehen, dass ein Richtungssignal erzeugt wird, das einen bezüglich der Messstelle in Rückwärtsrichtung liegenden intermittierenden Erdfehler anzeigt, wenn die Phasenlage der Stromspitzenwerte entgegengesetzt zur Phasenlage der Nullspannungswerte ist.

Auf diese Weise kann mit dem Richtungssignal eindeutig sowohl eine Vorwärts- als auch eine Rückwärtsrichtung eines intermittierenden Erdfehlers angegeben werden.

Eine weitere vorteilhafte Ausführungsform des erfindungsgemäßen Verfahrens sieht zudem vor, dass Vorhersagewerte gebildet werden, die einen erwarteten erdfehlerfreien Verlauf der Nullstrommesswerte angeben, ein Stromspitzenschwellenwert bestimmt wird, der dynamisch an die Höhe der Vorhersagewerte angepasst wird, und die Stromspitzenwerte aus denjenigen Nullstrommesswerten gebildet werden, deren Betrag den Stromspitzenschwellenwert überschreitet, wobei als Vorzeichen für die Stromspitzenwerte das Vorzeichen der jeweils zugehörigen Nullstrommesswerte verwendet wird.

Auf diese Weise lassen sich die zu der ersten beschriebenen zeitlichen Phase gehörenden Stromspitzenwerte mit relativ geringem Rechenaufwand und damit sehr schnell aus dem Verlauf der Nullstrommesswerte erkennen.

In diesem Zusammenhang kann zudem vorgesehen sein, dass die Vorhersagewerte unter Verwendung von den aktuellen Nullstrommesswerten zeitlich vorausgehenden Nullstrommesswerten gebildet werden.

Eine weitere vorteilhafte Ausführungsform sieht in diesem Zusammenhang vor, dass der jeweilige Wert des Stromspitzenschwellenwertes durch Multiplikation des Effektivwertes der Vorhersagewerte mit einem vorgegebenen Faktor ermittelt wird.

Eine weitere vorteilhafte Ausführungsform des erfindungsgemäßen Verfahrens besteht darin, dass zum Vergleich der Phasenlagen der Stromspitzenwerte und der Nullspannungsmesswerte das Vorzeichen der Stromspitzenwerte und das Vorzeichen der jeweils zeitlich zugehörigen Nullspannungsmesswerte bestimmt werden und der Vergleich der Phasenlagen durch einen Vergleich der jeweiligen Vorzeichen derart durchgeführt wird, dass bei übereinstimmenden Vorzeichen auf eine gleiche Phasenlage und bei verschiedenen Vorzeichen auf eine entgegen gesetzte Phasenlage geschlossen wird.

Auf diese Weise kann unter Verwendung eines vergleichsweise einfachen rechnerischen Vergleichsverfahrens eine Aussage über die Phasenlage der Stromspitzenwerte bezüglich der Nullspannungsmesswerte getroffen werden.

In diesem Zusammenhang kann zudem vorgesehen sein, dass Vergleichszeitbereiche bestimmt werden, in denen die jeweiligen positiven Maxima des Verlaufs der Nullspannungsmesswerte liegen, und der Vergleich der Vorzeichen für die jeweils innerhalb der Vergleichszeitbereiche liegenden Stromspitzenwerte und Nullspannungsmesswerte durchgeführt wird.

Hierdurch kann erreicht werden, dass ein Vergleich der Phasenlagen immer im Bereich der Maxima der Nullspannungsmesswerte durchgeführt wird.

Konkret kann in diesem Zusammenhang vorgesehen sein, dass die Vergleichszeitbereiche dadurch festgelegt werden, dass der Betrag des Verlaufs der Nullspannungsmesswerte mit einem Nullspannungsschwellenwert verglichen wird, wobei die Vergleichszeitbereiche jeweils dann vorliegen, wenn der Betrag der Nullspannungsmesswerte den Nullspannungsschwellenwert überschreitet.

Hierdurch lassen sich die Vergleichszeitbereiche sehr einfach festlegen, da hierzu lediglich ein Vergleich der Nullspannungsmesswerte mit einem Nullspannungsschwellenwert durchgeführt werden muss.

Hinsichtlich des Nullspannungsschwellenwertes kann zudem vorgesehen sein, dass der Nullspannungsschwellenwert dynamisch an die jeweilige Amplitude der Nullspannungsmesswerte angepasst wird.

Die oben genannte Aufgabe wird auch durch ein Schutzgerät nach Anspruch 10 gelöst. Das Schutzgerät zum Erkennen der Richtung eines intermittierenden Erdfehlers in einem elektrischen Energieversorgungsnetz weist eine Messwerterfassungseinrichtung zur Erfassung von Nullstrommesswerten und Nullspannungsmesswerten und einer Auswerteeinrichtung auf, die anhand der Nullstrom- und Nullspannungsmesswerte eine Erkennung der Richtung eines intermittierenden Erdfehlers durchführt. Erfindungsgemäß ist die Auswerteeinrichtung zur Durchführung eines Verfahrens gemäß einem der Ansprüche 1 bis 9 eingerichtet.

Die Erfindung soll im Folgenden anhand eines Ausführungsbeispiels näher erläutert werden. Hierzu zeigen
- Figur 1:: eine schematische Ansicht eines elektrischen Energieversorgungsnetzes mit hinsichtlich intermittierender Erdfehler überwachten Abzweig;
- Figur 2:: ein logisches Ablaufschaltbild zur Erläuterung der Vorgehensweise bei der Bestimmung der Richtung eines intermittierenden Erdfehlers;
- Figur 3:: ein Diagramm mit Verläufen von Nullstrommesswerten und Vorhersagewerten;
- Figur 4:: ein Diagramm zur Erläuterung der Bildung von Stromspitzenwerten aus dem Verlauf von Nullstrommesswerten;
- Figur 5:: ein Diagramm zur Erläuterung der Bildung von Vergleichszeitbereichen anhand des Verlaufs von Nullspannungsmesswerten; und
- Figur 6:: ein Diagramm zur Erläuterung der Bildung eines Richtungssignals anhand der Phasenlage von Nullspannungsmesswerten und Stromspitzenwerten.

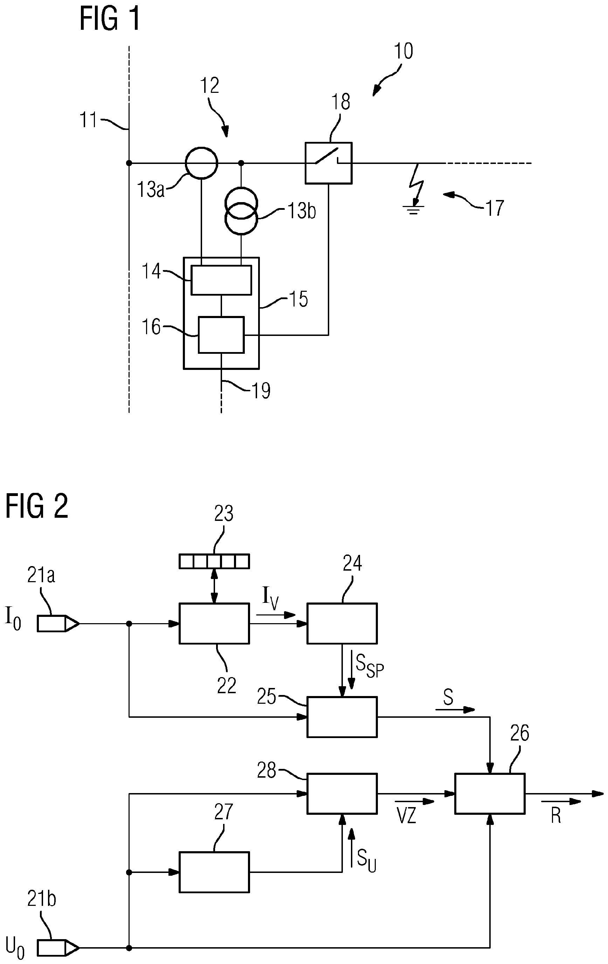

Figur 1 zeigt in schematischer Darstellung einen Abzweig 10 eines elektrischen Energieversorgungsnetzes, von dem der Übersichtlichkeit halber in Figur 1 lediglich eine Sammelschiene 11 gezeigt ist. Die Darstellung gemäß Figur 1 ist als so genanntes Single-Line-Diagramm ausgeführt; tatsächlich handelt es sich bei dem Energieversorgungsnetz jedoch um ein dreiphasiges Energieversorgungsnetz.

An einer Messstelle 12 des Abzweigs 10 sind Sensoren 13a und 13b zum Erfassen Nullstrommesswerten, die einen an der Messstelle 12 fließenden Nullstrom angeben, und Nullspannungsmesswerten, die eine an der Messstelle 12 anliegende Nullspannung angeben, vorgesehen. Lediglich beispielhaft sind die Sensoren 13a und 13b als induktive Strom- bzw. Spannungswandler dargestellt. Die Ermittlung von den Nullstrom- bzw. Nullspannungsmesswerten kann hierbei sowohl in messtechnischer Weise (beispielsweise die Erfassung des Nullstromes durch einen Umbaustromwandler) als auch in rechnerischer Weise erfolgen.

Die Nullstrommesswerte und die Nullspannungsmesswerte werden einer Messwerterfassungseinrichtung 14 eines lediglich schematisch angedeuteten Schutzgerätes 15 übermittelt. Anstelle der Erfassung der Nullstrom- und der Nullspannungsmesswerte direkt durch den Sensor ist es auch möglich, mit den Sensoren die jeweiligen Phasenstrom- und Phasenspannungsmesswerte an der Messstelle 12 abzugreifen und eine Umrechnung in Nullstrom- bzw. Nullspannungsmesswerte erst von der Messwerterfassungseinrichtung 14 vornehmen zu lassen. Ebenso kann eine Bildung von Nullstrom- bzw. Nullspannungsmesswerten auch in einer dem Schutzgerät vorgelagerten Merging Unit erfolgen.

In der Messwerterfassungseinrichtung 14 können darüber hinaus eine Analog-Digital-Umwandlung, Filterungen und weitere Vorverarbeitungen stattfinden. Eine Analog-Digital-Umwandlung kann jedoch auch außerhalb des Schutzgerätes in einer der Messwerterfassungseinrichtung 14 vorgelagerten Einrichtung (beispielsweise einer Merging Unit) stattfinden, so dass an das Schutzgerät 15 digitale Messwerte übertragen werden.

Das Schutzgerät 15 weist darüber hinaus eine Auswerteeinrichtung 16 auf, die anhand der Nullstrom- bzw. Nullspannungsmesswerte eine Überprüfung durchführt, ob ein intermittierender Erdfehler, d. h. ein kurzfristiger, wiederkehrender Erdfehler, vorliegt, und ob sich dieser von der Messstelle 12 aus gesehen in Vorwärts- oder Rückwärtsrichtung befindet. In Figur 1 ist beispielhaft ein intermittierender Erdfehler 17 angedeutet, der von der Messstelle 12 aus gesehen in Vorwärtsrichtung auf dem Abzweig 10 liegt. Würde ein intermittierender Erdfehler beispielsweise auf der Sammelschiene 11 vorliegen, so würde dieser von der Messstelle 12 aus gesehen in Rückwärtsrichtung auftreten.

Sofern das Schutzgerät 15 einen in Vorwärtsrichtung, also auf dem Abzweig 10, liegenden intermittierenden Erdfehler erkennt, soll der Abzweig 10 selektiv abgeschaltet werden. Hierzu gibt die Auswerteeinrichtung 16 ein Schaltsignal an einen lediglich schematisch angedeuteten Leistungsschalter 18 ab, der daraufhin den fehlerbehafteten Abzweig 10 abschaltet und vom übrigen Energieversorgungsnetz abtrennt. Darüber hinaus kann die Auswerteeinrichtung 16 über eine Kommunikationsschnittstelle 19 eine Meldung an andere Schutzgeräte oder eine übergeordnete Leiteinrichtung (z.B. eine Netzleitstelle) abgeben, um das Vorliegen eines intermittierenden Erdfehlers und dessen Richtung auch an andere Geräte oder den Betreiber des Energieversorgungsnetzes zu melden. Auf diese Weise können z.B. Instandsetzungsarbeiten zielgerichtet und zeitnah vorgenommen werden.

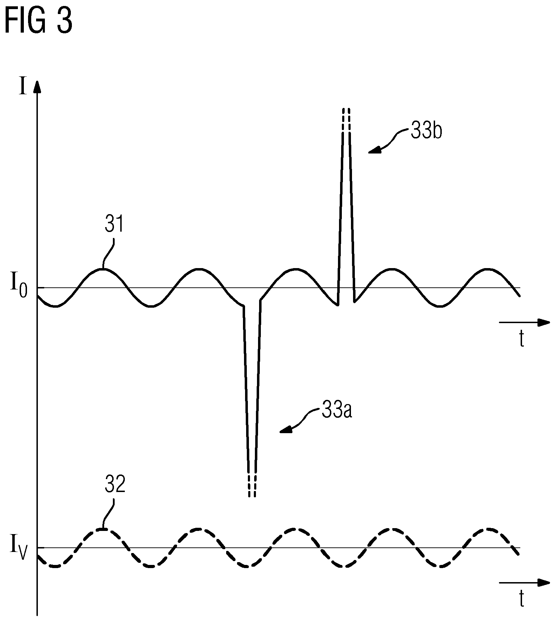

Die Vorgehensweise bei der Erkennung der Richtung eines intermittierenden Erdfehlers soll im Folgenden anhand der Figur 2 unter Hinzunahme der Diagramme in den Figuren 3 bis 6 näher erläutert werden.

Figur 2 zeigt hierzu ein logisches Ablaufschaltbild. An einem ersten Messwerteingang 21a werden Nullstrommesswerte I₀, an einem zweiten Messwerteingang 21b werden entsprechende Nullspannungsmesswerte U₀ bereitgestellt. Wie bereits erläutert, können diese Nullstrom- bzw. Nullspannungsmesswerte I₀ bzw. U₀ entweder messtechnisch erzeugt oder - beispielsweise von der Messwerterfassungseinrichtung 14 des Schutzgerätes 15 - auf Grund von Phasenstrommesswerten bzw. Phasenspannungsmesswerten berechnet werden. Die Nullstrom- bzw. Nullspannungsmesswerte I₀ bzw. U₀ sind zeitlich korreliert zueinander aufgenommen, d. h. es werden von dem Schutzgerät 15 jeweils solche Nullstrom- bzw. Nullspannungsmesswerte I₀ bzw. U₀ weiterverarbeitet, die zu demselben Zeitpunkt aufgenommen worden sind. Hierzu kann beispielsweise seitens der Messwerterfassungseinrichtung 14 des Schutzgerätes 15 eine Zeitstempelung der aufgenommenen Messwerte stattfinden und es werden immer Nullstrom- bzw. Nullspannungsmesswerte I₀ bzw. U₀ mit übereinstimmenden Zeitstempeln weiterverarbeitet.

Dem Messwerteingang 21a ist eine Prädiktoreinrichtung 22 zur Vorhersage von auf einen aktuellen Nullstrommesswert erwartungsgemäß folgenden weiteren Nullstrommesswerten vorgesehen. Die Prädiktoreinrichtung 22 greift hierzu auf eine Zwischenspeichereinrichtung 23 zu, in der dem aktuellen Nullstrommesswert zeitlich vorausgehende Nullstrommesswerte abgespeichert sind. Auf Grundlage dieser zeitlich vorausgehenden Nullstrommesswerte werden von der Prädiktoreinrichtung 22 in an sich bekannter Weise Vorhersagewerte bestimmt, die den erwarteten Verlauf von zukünftigen Nullstrommesswerten bei Abwesenheit eines intermittierenden Erdfehlers angeben. Beispielsweise können hierzu jeweils solche Nullstrommesswerte betrachtet werden, die dem auf den aktuellen Messwert nächstfolgenden Nullstrommesswert um eine Periode (oder um eine andere ganzzahlige Anzahl von Perioden) vorausgegangen sind. Dabei können bei Bedarf überlagerte Abklingvorgänge in Form von exponentiellen Abnahmen dieser vorhergehenden Werte berücksichtigt werden. Alternativ können hierzu bei Verwendung eines entsprechenden Vorhersagemodells (z.B. Modellierung eines weitgehend sinusförmigen Stromverlaufs) beispielsweise auch die letzten, dem aktuellen Messwert unmittelbar vorausgehenden Messwerte (z.B. die jeweils letzten 2 Messwerte) betrachtet und daraus der Vorhersagewert für den aktuellen Messwert ermittelt werden.

Figur 3 zeigt hierzu ein schematisches Diagramm, in dem einerseits ein Verlauf 31 von Nullstrommesswerten I₀ und andererseits ein Verlauf 32 von Vorhersagewerten Iᵥ dargestellt sind. Der Verlauf 31 der Nullstrommesswerte I₀ zeigt Stromspitzen 33a und 33b, die auf intermittierende Erdfehler zurückzuführen sind.

Für das Verfahren zur Erkennung der Richtung eines intermittierenden Erdfehlers ist aus dem Verlauf 31 der Nullstrommesswerte I₀ jeweils die zeitliche Lage der Stromspitzen 33a bzw. 33b sowie ihre Phasenlage zu abzuleiten. Hierzu findet zunächst in der Prädiktoreinrichtung 22 wie beschrieben die Bildung des Verlaufs 32 von Vorhersagewerten I_{V} statt, der quasi den Verlauf 31 der Nullstrommesswerte I₀ ohne die Stromspitzen 33a bzw. 33b angibt, da die Vorhersagewerte I_{V} den erwarteten zukünftigen Verlauf der Nullstrommesswerte bei Abwesenheit eines intermittierenden Erdfehlers angeben. Von der Prädiktoreinrichtung 22 werden ausgangsseitig die Vorhersagewerte I_{V} an einen ersten Schwellenwertbildner 24 abgegeben.

Der erste Schwellenwertbildner 24 ermittelt auf Grundlage der Vorhersagewerte I_{V} dynamisch einen Stromspitzenschwellenwert S_{SP}. Hierzu kann beispielsweise zunächst der Effektivwert der Vorhersagewerte I_{V} gebildet werden, und dieser kann nachfolgend mit einem vorgegebenen Faktor K multipliziert werden. Beispielsweise kann auf diese Weise durch Multiplikation mit dem Faktor K=1,5 der Stromspitzenschwellenwert S_{SP} bei 150 % des Effektivwertes der Vorhersagewerte I_{V} festgelegt werden.

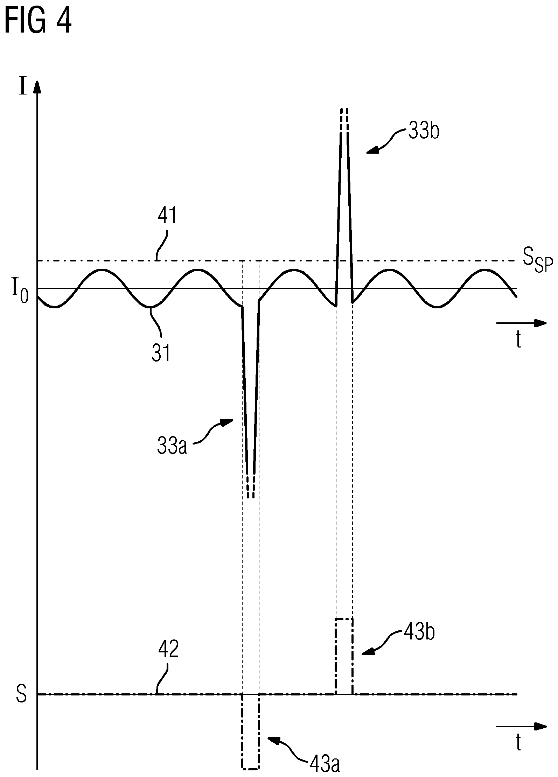

Figur 4 zeigt hierzu im oberen Teil des dargestellten Diagramms den bereits in Figur 3 gezeigten Verlauf 31 der Nullstrommesswerte I₀ sowie einen aus den Vorhersagewerten I₀ in oben beschriebener Weise ermittelten Verlauf 41 des Stromspitzenschwellenwert S_{SP} an. Der Stromspitzenschwellenwert S_{SP} wird herangezogen, um die Lage der die Stromspitzen 33a bzw. 33b umfassenden Stromspitzenwerte S zu erkennen.

Dies findet in einem in Figur 2 gezeigten Auswertungsbaustein 25 statt, dem eingangsseitig einerseits die Nullstrommesswerte I₀ zugeführt werden und andererseits der anhand der Vorhersagewerte I_{V} in dem ersten Schwellenwertbildner 24 ermittelte Stromspitzenschwellenwert S_{SP} zugeführt wird. Der Auswertungsbaustein 25 vergleicht den Betrag der Nullstrommesswerte I₀ mit dem Verlauf des Stromspitzenschwellenwertes S_{SP} und gibt ausgangsseitig immer dann Stromspitzenwerte S aus, wenn der Betrag der jeweiligen Nullstrommesswerte I₀ den Stromspitzenschwellenwert S_{SP} überschreitet. Das Vorzeichen der Stromspitzenwerte S richtet sich hierbei nach dem Vorzeichen der jeweils zugehörigen Nullstrommesswerte I₀, d. h., dass bei negativen Nullstrommesswerten I₀, deren Betrag oberhalb des Stromspitzenschwellenwertes S_{SP} liegt, negative Stromspitzenwerte S von dem Auswertungsbaustein 25 ausgegeben werden, während bei positiven Nullstrommesswerten I₀, deren Betrag oberhalb des Stromspitzenschwellenwertes S_{SP} liegt, positive Stromspitzenwerte S abgegeben werden.

Hierzu ist im unteren Verlauf des in Figur 4 gezeigten Diagramms ein Verlauf 42 von Stromspitzenwerten S dargestellt, der im Bereich 43a negative Stromspitzenwerte S aufweist, wenn die Nullstrommesswerte I₀ betragsmäßig den Stromspitzenschwellenwert S_{SP} übersteigen und ein negatives Vorzeichen aufweisen (Stromspitze 33a), während er im Bereich 43b positive Stromspitzenwerte S aufweist, wenn die Nullstrommesswerte I₀ betragsmäßig den Stromspitzenschwellenwertes S_{SP} übersteigen und ein positives Vorzeichen aufweisen (Stromspitze 33b) .

Der in Figur 4 gezeigte Verlauf 42 der Stromspitzenwerte S ist beispielhaft anhand eines Signalverlaufes mit den Werten Low (Null) sowie High (positiv) und High (negativ) dargestellt. Stattdessen könnte jedoch auch ein Verlauf der Stromspitzenwerte verwendet werden, dessen Form dem kontinuierlichen Verlauf der Stromspitzen 33a bzw. 33b angepasst ist.

Der Verlauf 42 der Stromspitzenwerte S wird von dem Auswertungsbaustein 25 ausgangsseitig an eine Richtungsbestimmungseinrichtung 26 übermittelt.

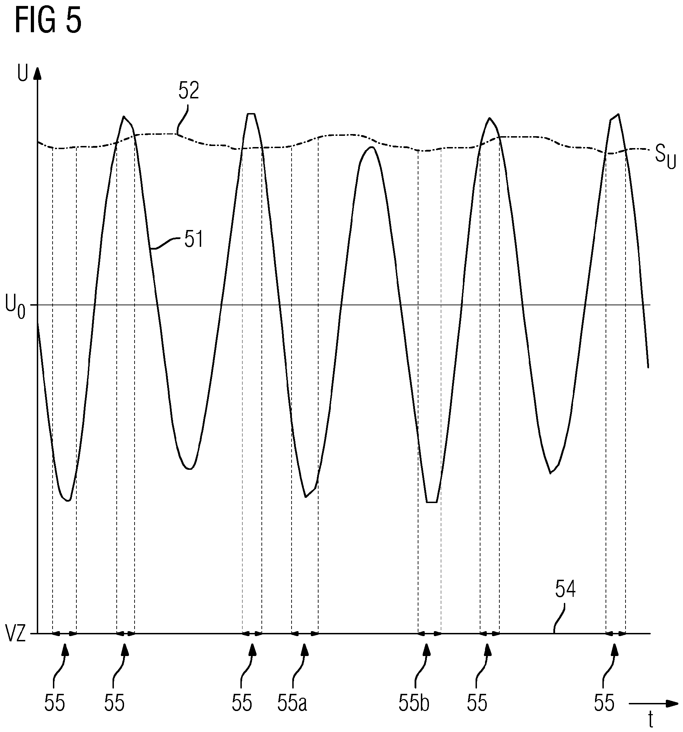

Der Verlauf der Nullspannungsmesswerte U₀ wird vom zweiten Messwerteingang 21b einem zweiten Schwellenwertbildner 27 zugeführt. Der zweite Schwellenwertbildner 27 ermittelt einen Nullspannungsschwellenwert S_{U}, dessen Höhe beispielsweise in dynamischer Weise abhängig von der mittleren Amplitude der Nullspannungsmesswerte U₀ festgelegt wird. Hierzu zeigt Figur 5 ein Diagramm, in dem einerseits ein Verlauf 51 von Nullspannungsmesswerten U₀ und andererseits ein Verlauf 52 eines Nullspannungsschwellenwertes S_{U} eingetragen ist, dessen Höhe abhängig von der mittleren Amplitude der Nullspannungsmesswerte U₀ ist. Der in Figur 5 lediglich beispielhaft gezeigte Verlauf 52 des Nullspannungsschwellenwertes S_{U} weist beispielsweise einen Wert von 90 % der mittleren Amplitude der Nullspannungsmesswerte U₀ auf.

Der Nullspannungsschwellenwert S_{U} wird von dem zweiten Schwellenwertbildner 27 ausgangsseitig einer Zeitbereichsbestimmungseinrichtung 28 zugeführt, an der eingangsseitig außerdem auch die Nullspannungsmesswerte U₀ anliegen. Die Zeitbereichsbestimmungseinrichtung 27 ermittelt Vergleichszeitbereiche VZ, die solche Zeitbereiche angeben, in denen der Betrag der Nullspannungsmesswerte U₀ oberhalb des Nullspannungsschwellenwertes S_{U} liegt. Figur 5 zeigt im unteren Bereich des Diagramms eine Abfolge von Vergleichszeitbereichen VZ (Bezugszeichen 55, 55a, 55b) auf einer Zeitachse 54. Diese Vergleichszeitbereiche VZ 55, 55a, 55b stellen Zeitbereiche dar, in denen Maxima des Verlaufs 51 der Nullspannungsmesswerte U₀ auftreten. Die Vergleichszeitbereiche VZ 55, 55a, 55b werden von der Zeitbereichsbestimmungseinrichtung 28 ausgangsseitig abgegeben und der Richtungsbestimmungseinrichtung 26 zugeführt, der eingangsseitig wie oben beschrieben auch die Stromspitzenwerte S übermittelt werden. An einem dritten Eingang der Richtungsbestimmungseinrichtung 26 liegen die Nullspannungsmesswerte U₀ an.

In der Richtungsbestimmungseinrichtung 26 wird nun innerhalb der durch die Vergleichszeitbereiche VZ festgelegten Zeitfenster eine Überprüfung der Phasenlagen des Verlaufs der Nullspannungsmesswerte U₀ einerseits und des Verlaufs der Stromspitzenwerte S andererseits durchgeführt. Sofern übereinstimmende Phasenlagen festgestellt werden, erkennt die Richtungsbestimmungseinrichtung 26 einen Vorwärtsfehler und gibt ein entsprechendes Richtungssignal R ab.

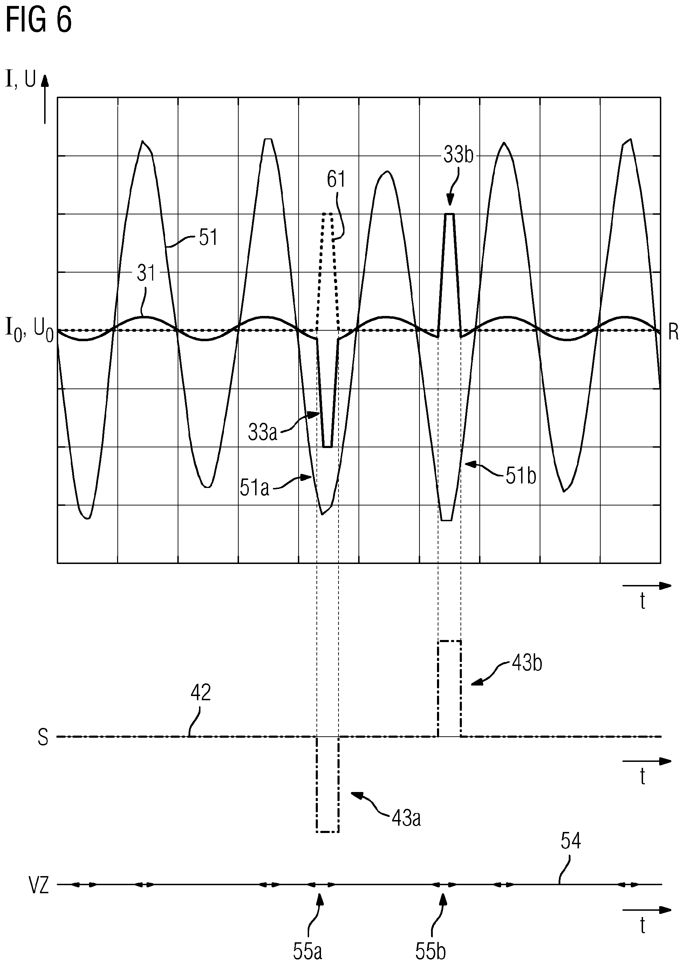

Dies ist in Figur 6 veranschaulicht, die ein Diagramm zeigt, in dem einerseits der Verlauf 51 der Nullspannungsmesswerte U₀ und andererseits der Verlauf 31 der Nullstrommesswerte I₀ dargestellt sind. Des Weiteren ist der Verlauf 42 der Stromspitzenwerte S eingetragen, der mit den Stromspitzen 33a, 33b des Verlaufs 31 der Nullstrommesswerte I₀ korreliert und in zuvor erläuterter Weise davon abgeleitet ist. Außerdem ist die Lage der Vergleichszeitbereiche VZ auf der Zeitachse 54 eingetragen.

Innerhalb der von den Vergleichszeitbereichen VZ angegebenen Zeitfenster findet eine Überprüfung der Phasenlage der Nullspannungsmesswerte U₀ und der Stromspitzenwerte S statt. Man erkennt, dass lediglich in den durch die Bezugszeichen 55a und 55b bezeichneten Vergleichszeitbereichen VZ Stromspitzenwerte S (in den Bereichen 43a und 43b) auftreten. Ein Vergleich der Phasenlagen ergibt, dass bei der Stromspitze 33a im Vergleichszeitbereich 55a sowohl die Stromspitzenwerte 43a als auch die Nullspannungsmesswerte U₀ (im Bereich 51a) ein negatives Vorzeichen und damit eine übereinstimmende Phasenlage aufweisen. Somit erkennt die Richtungsbestimmungseinrichtung 26 einen in Vorwärtsrichtung liegenden intermittierenden Erdfehler und gibt ausgangsseitig ein entsprechendes Richtungssignal R ab. Dieses ist in dem Diagramm in Figur 6 als Verlauf 61 dargestellt.
Bei der Stromspitze 33b im Vergleichszeitbereiches 55b treten Stromspitzenwerte S mit positivem Vorzeichen (Bereich 43b) auf, denen im Bereich 51b Nullspannungsmesswerte U₀ mit negativem Vorzeichen gegenüber stehen, so dass die Phasenlagen der Stromspitzenwerte S und der Nullspannungsmesswerte U₀ in diesem Fall entgegengesetzt sind. Entsprechend erkennt die Richtungsbestimmungseinrichtung 26 einen in Rückwärtsrichtung liegenden intermittierenden Erdfehler. Bei dem Ausführungsbeispiel gemäß Figur 6 wird in diesem Fall kein Richtungssignal abgegeben (Verlauf 61 weist den Wert Null auf). Alternativ könnte auch ein eine Rückwärtsrichtung anzeigendes Fehlersignal abgegeben werden, um den Fehlerfall eindeutig sowohl in Vorwärts- als auch in Rückwärtsrichtung von einem fehlerfreien Fall unterscheiden zu können.

Obwohl bei dem Ausführungsbeispiel gemäß Figur 2 auf ein Logikschaltbild Bezug genommen worden ist, wird die Funktionsweise zur Erkennung der Richtung eines intermittierenden Erdfehlers in der Auswerteeinrichtung 16 des Schutzgerätes 15 (vgl. Figur 1) üblicherweise mittels einer Gerätesoftware implementiert sein. Die in Figur 2 gezeigten Funktionsbausteine stellen dann Anweisungen und Module eines entsprechenden Programms der Gerätesoftware dar.

Bei dem anhand der Figuren 2 bis 6 beschriebenen Ausführungsbeispiel wurde ein Vergleich der Phasenlagen der Nullspannungsmesswerte U₀ und der Stromspitzenwerte S in vereinfachter Weise anhand der jeweiligen Vorzeichen der Verläufe der Nullspannungsmesswerte U₀ und der Stromspitzenwerte S im Bereich der Maxima der Nullspannungsmesswerte U₀ durchgeführt. Alternativ dazu kann beispielsweise auch ein Vergleich anhand von explizit bestimmten Phasenwinkeln der Nullspannungsmesswerte U₀ als auch der Stromspitzenwerte S stattfinden. Dies kann beispielsweise dann durchgeführt werden, wenn sowohl die Nullspannungsmesswerte U₀ als auch die Nullstrommesswerte I₀ in Form von Zeigermesswerten (Phasoren) vorliegen, die ohnehin eine Angabe über Amplitude und Phasenwinkel der jeweiligen Messwerte beinhalten.

## Patentansprüche

1. Verfahren zum Erzeugen eines Richtungssignals, das eine Richtung angibt, in der sich ein intermittierender Erdfehler (17) in einem elektrischen Energieversorgungsnetz befindet, wobei einen Nullstrom angebende Nullstrommesswerte und eine Nullspannung angebende Nullspannungswerte erfasst und von einem Schutzgerät (15) zur Bildung des Richtungssignals herangezogen werden, wobei
- Stromspitzenwerte als derjenige Anteil aus dem Verlauf der Nullstrommesswerte bestimmt werden, der zumindest eine einen intermittierenden Erdfehler (17) angebende Stromspitze umfasst; und
- die Phasenlage des Verlaufs der Stromspitzenwerte mit der Phasenlage des Verlaufs der Nullspannungsmesswerte verglichen wird;
**dadurch gekennzeichnet, dass**
- die Nullstrommesswerte und die Nullspannungsmesswerte an derselben Messstelle (12) des Energieversorgungsnetzes erfasst werden; und
- ein Richtungssignal erzeugt wird, das einen bezüglich der Messstelle (12) in Vorwärtsrichtung liegenden intermittierenden Erdfehler (17) anzeigt, wenn die Phasenlage der Stromspitzenwerte mit der Phasenlage der Nullspannungswerte übereinstimmt .

2. Verfahren nach Anspruch 1,
**dadurch gekennzeichnet, dass**
- ein Richtungssignal erzeugt wird, das einen bezüglich der Messstelle (12) in Rückwärtsrichtung liegenden intermittierenden Erdfehler anzeigt, wenn die Phasenlage der Stromspitzenwerte entgegengesetzt zur Phasenlage der Nullspannungswerte ist.

3. Verfahren nach Anspruch 1 oder 2,
**dadurch gekennzeichnet, dass**
- Vorhersagewerte gebildet werden, die einen erwarteten erdfehlerfreien Verlauf der Nullstrommesswerte angeben;
- ein Stromspitzenschwellenwert bestimmt wird, der dynamisch an die Höhe der Vorhersagewerte angepasst wird; und
- die Stromspitzenwerte aus denjenigen Nullstrommesswerten gebildet werden, deren Betrag den Stromspitzenschwellenwert überschreitet, wobei als Vorzeichen für die Stromspitzenwerte das Vorzeichen der jeweils zugehörigen Nullstrommesswerte verwendet wird.

4. Verfahren nach Anspruch 3,
**dadurch gekennzeichnet, dass**
- die Vorhersagewerte unter Verwendung von den aktuellen Nullstrommesswerten zeitlich vorausgehenden Nullstrommesswerten gebildet werden.

5. Verfahren nach Anspruch 3 oder 4,
**dadurch gekennzeichnet, dass**
- der jeweilige Wert des Stromspitzenschwellenwertes durch Multiplikation des Effektivwertes der Vorhersagewerte mit einem vorgegebenen Faktor ermittelt wird.

6. Verfahren nach einem der vorangehenden Ansprüche,
**dadurch gekennzeichnet, dass**
- zum Vergleich der Phasenlagen der Stromspitzenwerte und der Nullspannungsmesswerte das Vorzeichen der Stromspitzenwerte und das Vorzeichen der jeweils zeitlich zugehörigen Nullspannungsmesswerte bestimmt werden und der Vergleich der Phasenlagen durch einen Vergleich der jeweiligen Vorzeichen derart durchgeführt wird, dass bei übereinstimmenden Vorzeichen auf eine gleiche Phasenlage und bei verschiedenen Vorzeichen auf eine entgegengesetzte Phasenlage geschlossen wird.

7. Verfahren nach Anspruch 6,
**dadurch gekennzeichnet, dass**
- Vergleichszeitbereiche bestimmt werden, in denen die jeweiligen positiven Maxima des Verlaufs der Nullspannungsmesswerte liegen, und der Vergleich der Vorzeichen für die jeweils innerhalb der Vergleichszeitbereiche liegenden Stromspitzenwerte und Nullspannungsmesswerte durchgeführt wird.

8. Verfahren nach Anspruch 7,
**dadurch gekennzeichnet, dass**
- die Vergleichszeitbereiche dadurch festgelegt werden, dass der Betrag des Verlaufs der Nullspannungsmesswerte mit einem Nullspannungsschwellenwert verglichen wird, wobei die Vergleichszeitbereiche jeweils dann vorliegen, wenn der Betrag der Nullspannungsmesswerte den Nullspannungsschwellenwert überschreitet.

9. Verfahren nach Anspruch 8,
**dadurch gekennzeichnet, dass**
- der Nullspannungsschwellenwert dynamisch an die jeweilige Amplitude der Nullspannungsmesswerte angepasst wird.

10. Schutzgerät (15) zum Erkennen der Richtung eines intermittierenden Erdfehlers (17) in einem elektrischen Energieversorgungsnetz, mit
- einer Messwerterfassungseinrichtung (14) zur Erfassung von Nullstrommesswerten und Nullspannungsmesswerten; und
- einer Auswerteeinrichtung (16), die anhand der Nullstrom- und Nullspannungsmesswerte eine Erkennung der Richtung eines intermittierenden Erdfehlers (17) durchführt;
**dadurch gekennzeichnet, dass**
- die Auswerteeinrichtung (16) zur Durchführung eines Verfahrens gemäß einem der Ansprüche 1 bis 9 eingerichtet ist.

## Claims

1. Method for generating a direction signal indicating a direction in which an intermittent earth fault (17) in an electrical energy supply network is located, wherein zero current measurement values indicating a zero current and zero voltage values indicating a zero voltage are detected and are used by a protection apparatus (15) to form the direction signal, wherein
- current peak values are determined as that portion from the profile of the zero current measurement values which comprises at least one current peak indicating an intermittent earth fault (17); and
- the phase angle of the profile of the current peak values is compared with the phase angle of the profile of the zero voltage measurement values;
**characterized in that**
- the zero current measurement values and the zero voltage measurement values are detected at the same measurement location (12) of the energy supply network; and
- a direction signal is generated which indicates an intermittent earth fault (17) situated in the forward direction with respect to the measurement location (12) if the phase angle of the current peak values corresponds to the phase angle of the zero voltage values.

2. Method according to Claim 1,
**characterized in that**
- a direction signal is generated which indicates an intermittent earth fault situated in the reverse direction with respect to the measurement location (12) if the phase angle of the current peak values is opposite to the phase angle of the zero voltage values.

3. Method according to Claim 1 or 2,
**characterized in that**
- predicted values are formed which indicate an expected earth-fault-free profile of the zero current measurement values;
- a current peak threshold value is determined which is dynamically adapted to the magnitude of the predicted values; and
- the current peak values are formed from those zero current measurement values whose absolute value exceeds the current peak threshold value, wherein the sign of the respectively associated zero current measurement values is used as sign for the current peak values.

4. Method according to Claim 3,
**characterized in that**
- the predicted values are formed using zero current measurement values temporally preceding the present zero current measurement values.

5. Method according to Claim 3 or 4,
**characterized in that**
- the respective value of the current peak threshold value is determined by multiplying the root-mean-square value of the predicted values by a predefined factor.

6. Method according to any of the preceding claims,
**characterized in that**
- in order to compare the phase angles of the current peak values and of the zero voltage measurement values, the sign of the current peak values and the sign of the respectively temporally associated zero voltage measurement values are determined and the comparison of the phase angles is carried out by means of a comparison of the respective signs in such a way that an identical phase angle is deduced in the event of corresponding signs and an opposite phase angle is deduced in the event of different signs.

7. Method according to Claim 6,
**characterized in that**
- comparison time ranges are determined in which the respective positive maxima of the profile of the zero voltage measurement values lie, and the comparison of the signs is carried out for the current peak values and zero voltage measurement values respectively lying within the comparison time ranges.

8. Method according to Claim 7,
**characterized in that**
- the comparison time ranges are defined by the absolute value of the profile of the zero voltage measurement values being compared with a zero voltage threshold value, wherein the comparison time ranges are present in each case when the absolute value of the zero voltage measurement values exceeds the zero voltage threshold value.

9. Method according to Claim 8,
**characterized in that**
- the zero voltage threshold value is adapted dynamically to the respective amplitude of the zero voltage measurement values.

10. Protection apparatus (15) for identifying the direction of an intermittent earth fault (17) in an electrical energy supply network, comprising
- a measurement value detection device (14) for detecting zero current measurement values and zero voltage measurement values; and
- an evaluation device (16), which carries out an identification of the direction of an intermittent earth fault (17) on the basis of the zero current and zero voltage measurement values;
**characterized in that**
- the evaluation device (16) is designed for carrying out a method according to any of claims 1 to 9.

## Revendications

1. Procédé de production d'un signal de sens, qui indique un sens dans lequel a lieu un défaut ( 17 ) de terre intermittent dans un réseau de distribution d'énergie électrique, dans lequel on détecte des valeurs de mesure de courant nul, indiquant un courant nul, et des valeurs de tension nulle, indiquant une tension nulle, et on en tire partie, par un appareil ( 15 ) de protection, pour former le signal de sens, dans lequel
- on définit des valeurs de crête de courant comme la partie de la courbe des valeurs de mesure de courant nul, qui comprend au moins une crête de courant indiquant un défaut ( 17 ) de terre intermittent et
- on compare la position en phase de la courbe des valeurs de crête de courant à la position en phase de la courbe des valeurs de mesure de tension nulle ;
**caractérisé en ce que**
- on détecte les valeurs de mesure de courant nul et les valeurs de mesure de tension nulle au même point ( 12 ) de mesure du réseau de distribution d'énergie électrique et
- on produit un signal de sens, qui indique le défaut ( 17 ) de terre intermittent se trouvant dans le sens vers l'avant par rapport au point ( 12 ) de mesure, si la position en phase des valeurs de crête de courant coïncide avec la position en phase des valeurs de tension nulle.

2. Procédé suivant la revendication 1,
**caractérisé en ce que**
- on produit un signal de sens, qui indique un défaut de terre intermittent se trouvant dans le sens vers l'arrière par rapport au point ( 12 ) de mesure, si la position en phase des valeurs de crête de courant est opposée à la position en phase des valeurs de tension nulle.

3. Procédé suivant la revendication 1 ou 2,
**caractérisé en ce que**
- on forme des valeurs de prédiction, qui indiquent une courbe escomptée sans défaut de terre des valeurs de mesure de courant nul ;
- on définit une valeur de seuil de crête de courant, que l'on adapte dynamiquement au niveau des valeurs de prédiction et
- on forme les valeurs de crête de courant à partir des valeurs de mesure de courant nul, dont la valeur absolue dépasse la valeur de seuil de crête de courant, en utilisant, comme signe, pour les valeurs de crête de courant, le signe des valeurs de mesure de courant nul associées.

4. Procédé suivant la revendication 3,
**caractérisé en ce que**
- on forme les valeurs de prédiction en utilisant des valeurs de mesure de courant nul précédant dans le temps des valeurs de mesure de courant nul en cours.

5. Procédé suivant la revendication 3 ou 4,
**caractérisé en ce que**
- on détermine la valeur de seuil de crête du courant en multipliant la valeur efficace des valeurs de prédiction par un facteur donné à l'avance.

6. Procédé suivant l'une des revendications précédentes,
**caractérisé en ce que**
- pour comparer des positions en phase des valeurs de crête de courant et des valeurs de mesure de tension nulle, on détermine le signe des valeurs de crête de courant et le signe des valeurs de mesure de tension nulle associées dans le temps et on effectue la comparaison des positions en phase par une comparaison des signes respectifs, de manière à ce que, si les signes coïncident, on en déduit une même position en phase et si les signes sont différents, on en déduit une position en phase opposée.

7. Procédé suivant la revendication 6,
**caractérisé en ce que**
- on définit des domaines temporels de comparaison dans lesquels se trouvent les maximum positifs de la courbe des valeurs de mesure de tension nulle et on effectue la comparaison des signes pour les valeurs de crête de courant et les valeurs de mesure de tension nulle se trouvant dans les domaines temporels de comparaison.

8. Procédé suivant la revendication 7,
**caractérisé en ce que**
- on fixe les domaines temporels de comparaison en comparant la valeur absolue de la courbe des valeurs de mesure de tension nulle à une valeur de seuil de tension nulle, les domaines temporels de comparaison étant présents si la valeur absolue des valeurs de mesure de tension nulle dépasse la valeur de seuil de tension nulle.

9. Procédé suivant la revendication 8,
**caractérisé en ce que**
- on adapte la valeur de seuil de tension nulle dynamiquement à l'amplitude des valeurs de mesure de tension nulle.

10. Appareil ( 15 ) de protection, pour reconnaître le sens d'un défaut ( 17 ) de terre intermittent dans un réseau de distribution d'énergie électrique, comprenant
- un dispositif ( 14 ) de détection de valeur de mesure, pour détecter des valeurs de mesure de courant nul et des valeurs de mesure de tension nulle et
- un dispositif ( 16 ) d'exploitation, qui, au moyen des valeurs de mesure de courant nul et des valeurs de mesure de tension nulle, effectue une reconnaissance du sens d'un défaut ( 17 ) de terre intermittent ;
**caractérisé en ce que**
- le dispositif ( 16 ) d'exploitation est conçu pour effectuer un procédé suivant l'une des revendications 1 à 9.
